# DEMANDE DE BREVET EUROPEEN

(11) **EP 1 858 081 A1**
(43) Date de publication de la demande: **21.11.2007**
(21) Numéro de dépôt: 07104850.8
(22) Date de dépôt: 26.03.2007
(51) Int. Cl.: H01L 23/66

(54) **Circuit integré au silicium fonctionnant en hyperfrequence et procédé de fabrication**

(30) Priorité: 26.04.2006 FR 0603728
(71) Demandeur: COMMISSARIAT A L'ENERGIE ATOMIQUE, 75015 Paris (FR); ST MICROELECTRONICS S.A., 92120 Montrouge (FR)
(72) Inventeur: Cuchet, Robert, 38930 Monestier de Percy (FR); Pruvost, Sébastien, 38190 Froges (FR)
(74) Mandataire: Guérin, Michel

(57) **Abrégé**

L'invention concerne les circuits intégrés pour applications en hyperfréquence, dans la gamme des longueurs d'onde millimétriques (fréquences de l'ordre de 50 GHz).

Pour améliorer les performances des lignes de transmission hyperfréquence dans le circuit, on propose une structure de vias conducteurs entre une ligne de transmission (28) et une zone conductrice (16). Les vias sont formés dans des ouvertures (26) d'une couche de benzo-cyclo-butène (24) ; ces ouvertures sont plus grandes, à leur base, que les zones conductrices (16) ; la ligne de transmission (28) descend dans l'ouverture mais ne remonte pas sur les bords de l'ouverture. On minimise les capacités parasites avec le substrat à l'endroit du contact.

## Description

L'invention concerne les circuits intégrés pour applications en hyperfréquence, dans la gamme des longueurs d'onde millimétriques (fréquences de l'ordre de 50 GHz).

Ces circuits intégrés utilisent couramment des matériaux semiconducteurs dits III-V, c'est-à-dire des composés d'un élément de la colonne III du tableau de classification périodique de Mendeleïev, typiquement du gallium mais parfois aussi de l'indium, et d'un élément de la colonne V, typiquement de l'arsenic, parfois du phosphore. Le matériau le plus courant pour ces applications est l'arséniure de gallium. Le brevet US 5 202 752 donne un exemple d'un tel circuit-intégré sur substrat d'Arséniure de Gallium.

Les technologies de fabrication pour ces matériaux sont coûteuses, et c'est pourquoi on cherche à éviter de les utiliser, en poussant au maximum les performances des technologies à base de silicium ou éventuellement de germanium, qui sont plus simples, mieux maîtrisées, et qui permettent de plus en plus de travailler à très haute fréquence au fur et à mesure de la réduction des dimensions des motifs élémentaires gravés.

Pour les applications millimétriques, un inconvénient de l'utilisation d'un substrat de silicium ou de germanium est sa faible résistivité : contrairement aux substrats d'arséniure de gallium qui sont très isolants lorsqu'ils sont non dopés (non intentionnellement dopés), le substrat de silicium sur lequel sont intégrés les circuits millimétriques est suffisamment conducteur, même peu dopé, pour influencer de manière indésirable la propagation du signal dans les circuits de transmission hyperfréquence formés sur sa surface : un substrat trop conducteur est source de pertes de transmission par suite des capacités parasites qu'il engendre. Le problème est le même pour un substrat de germanium.

Le circuit intégré qu'on va réaliser comporte d'une part des éléments actifs, tels que des transistors, formés dans le semiconducteur, et des lignes de transmission entre ces éléments actifs. Ce sont ces lignes de transmission qu'il faut réaliser avec soin pour que leurs éléments parasites (capacités parasites, notamment avec le substrat, inductances parasites) ne perturbent pas la répartition des lignes de champ électromagnétiques d'une manière qui dégraderait les performances électriques du circuit intégré.

Les lignes de transmission sont de préférence réalisées en utilisant comme diélectrique entre conducteurs, ou entre un conducteur et le substrat de silicium, du Benzo-Cyclo-Butène, couramment appelé BCB. Ce matériau possède en effet de très bonnes performances diélectriques en hyperfréquence. Mais il subsiste des risques de défaut des lignes notamment à l'endroit où il faut interconnecter à travers le diélectrique deux lignes placées sur deux niveaux différents, ou une ligne avec un élément de circuit intégré dans le silicium proprement dit (essentiellement un transistor). En effet, les vias de connexion, prévus à travers le diélectrique BCB pour relier entre eux une ligne de transmission et un élément intégré dans le silicium, sont des sources de perturbations de la transmission hyperfréquence, et ceci d'autant plus que le substrat de silicium est conducteur.

Pour éviter les capacités parasites, on devrait augmenter les épaisseurs de BCB, mais alors la réalisation des vias entre niveaux devient plus difficile et plus encombrante.

L'invention propose une structure de via permettant d'améliorer les performances, et un procédé de fabrication correspondant.

On propose donc selon l'invention un procédé de fabrication d'un circuit intégré hyperfréquence sur un substrat de silicium ou germanium, comprenant la réalisation sur une face principale du substrat d'éléments actifs et d'au moins une zone de connexion conductrice pour la liaison entre un élément actif et une ligne de transmission hyperfréquence, le dépôt d'au moins une couche diélectrique sur la face principale du substrat, la réalisation dans la couche diélectrique d'une ouverture dénudant la zone de connexion, la formation sur la face principale d'une couche conductrice selon une géométrie correspondant à la ligne de transmission, ce procédé étant caractérisé en ce que la base de l'ouverture est plus grande que la zone de connexion dénudée par l'ouverture et en ce que la géométrie de la ligne de transmission définit un motif de ligne qui descend dans l'ouverture et recouvre une partie seulement de la surface de zone de connexion dénudée par l'ouverture.

La ligne de liaison ne recouvre donc pas la totalité de la partie dénudée de la zone de connexion qui elle-même n'occupe pas la totalité du fond de l'ouverture formée dans la couche diélectrique ; la ligne de transmission descend dans l'ouverture mais ne remonte pas sur tous les bords de l'ouverture comme c'était le cas dans l'art antérieur.

Cette structure permet, comme on le verra, de minimiser, pour une dimension donnée d'ouverture dans la couche diélectrique, la surface de conducteur (notamment la surface de la zone de connexion) qui risque de créer des capacités parasites avec le substrat sous-jacent.

Grâce à ce procédé on contrôle mieux les caractéristiques de la liaison électrique hyperfréquence entre la ligne de transmission et les zones conductrices sous-jacentes malgré le fait que les couches diélectriques, qui sont relativement épaisses, obligent à former des ouvertures assez larges au-dessus des zones conductrices. Les pertes de propagation sont réduites.

Les zones conductrices mentionnées ci-dessus sont en principe des zones directement intégrées dans le substrat semiconducteur au niveau des éléments actifs, mais elles peuvent aussi être des portions d'autres lignes de transmission reposant sur une couche diélectrique recouvrant les éléments actifs : le procédé est le même dans les deux cas.

Les couches diélectriques sont de préférence en BCB. Les lignes de transmission sont de préférence en cuivre, et le procédé de dépôt peut être un procédé électrolytique. Les zones conductrices, si elles sont intégrées au niveau des éléments actifs du substrat, au-dessous d'un premier niveau de BCB, sont de préférence en aluminium. Les lignes de transmission peuvent aussi être en aluminium ou en alliage d'aluminium et de silicium.

La définition de la géométrie des lignes de transmission peut être effectuée par une double étape d'insolation à travers deux masques dont l'un comporte un motif définissant précisément la ligne de transmission au-dessus de la couche de BCB et l'autre comporte un motif permettant l'ouverture de la résine principalement dans l'ouverture et sur les flancs mais pas ou pratiquement pas sur le reste de la couche de BCB.

Le circuit intégré selon l'invention, destiné à fonctionner en hyperfréquence, comporte donc au moins un substrat de silicium sur la face principale duquel est intégré au moins un élément actif ou passif avec une zone de connexion conductrice connectée à cet élément, une couche diélectrique recouvrant la face principale du substrat, une ligne de transmission hyperfréquence conductrice déposée au-dessus de la couche diélectrique, et une ouverture à travers la couche diélectrique au-dessus de la zone de connexion, caractérisé en ce que la base de l'ouverture est plus grande que la zone de connexion dénudée par l'ouverture et en ce que la ligne de transmission descend le long d'une pente oblique d'un flanc de l'ouverture et vient en contact avec la zone de connexion sur une surface plus faible que la surface de zone de connexion dénudée par l'ouverture.

La ligne de transmission s'arrête de préférence sur la zone de connexion sans remonter sur tous les bords de l'ouverture formée dans la couche diélectrique.

D'autres caractéristiques et avantages de l'invention apparaîtront à la lecture de la description détaillée qui suit et qui est faite en référence aux dessins annexés dans lesquels :
- la figure 1 représente une vue de dessus d'une liaison conductrice classique de circuit intégré hyperfréquence, entre une ligne conductrice et les éléments actifs ou passifs du circuit intégré ;
- la figure 2 représente une vue en coupe correspondant à la figure 1 ;
- la figure 3 représente une vue de dessus d'une liaison selon l'invention ;
- la figure 4 représente une section correspondante selon la ligne IV-IV de la figure 3 ;
- la figure 5 représente une section selon la ligne V-V de la figure 3 ;
- les figures 6 à 14 représentent les différentes étapes de fabrication de la structure de via conducteur selon l'invention.

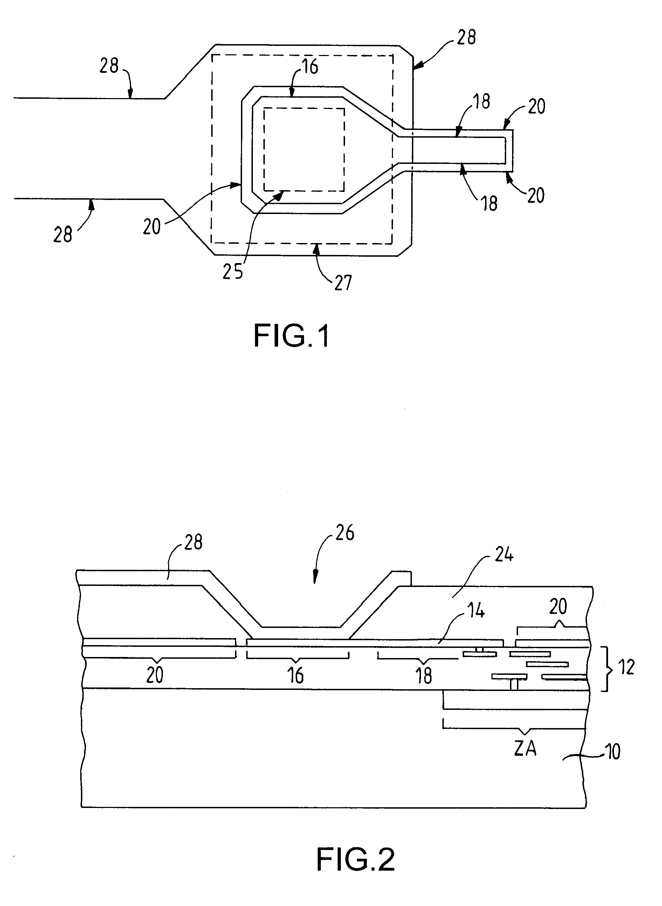

Les figures 1 et 2 sont décrites simultanément : le circuit intégré hyperfréquence est réalisé sur une face principale (face avant) d'un substrat de silicium 10. Le substrat pourrait être aussi en germanium mais dans la suite on considérera qu'il s'agit de silicium qui est un matériau plus avantageux du point de vue de la maîtrise industrielle de son utilisation. Les éléments actifs ou passifs de ce circuit sont formés dans une zone active globalement désignée par la référence ZA (figure 2), qui comprend à la fois les éléments actifs ou passifs et des interconnexions sur plusieurs niveaux métalliques ; les éléments actifs sont essentiellement des transistors. Les couches d'interconnexion interne au circuit intégré sont réalisées par des niveaux métalliques (aluminium en général) noyés dans des couches isolantes qui sont le plus souvent en oxyde de silicium. Les différents niveaux sont connectés entre eux par des vias conducteurs. L'ensemble de la couche isolante incorporant ces différents niveaux métalliques d'interconnexion et les vias de connexion est désigné par la référence 12. Le dernier niveau d'interconnexion, qui va servir à relier les éléments actifs ou passifs à des lignes de transmission hyperfréquence, est désigné par la référence 14. Ce dernier niveau peut être en aluminium, éventuellement revêtu d'une fine couche de titane ou d'un métal similaire (tantale, tungstène par exemple).

L'invention concerne plus particulièrement la liaison entre ce dernier niveau d'interconnexion 14 et une ligne de transmission hyperfréquence réalisée à un niveau supérieur sur la même face principale du circuit intégré.

Dans une réalisation classique telle que celle des figures 1 et 2, la liaison se fait de la manière suivante : le dernier niveau d'aluminium 14 comporte au moins une zone de connexion conductrice 16, reliée à un conducteur 18 du même niveau, ce conducteur étant lui-même relié à un élément actif ou passif par l'intermédiaire des couches d'interconnexion mentionnées précédemment. On notera que la zone conductrice 16 et le conducteur 18 peuvent être entourés par un conducteur de masse 20 pour former un guide d'onde coplanaire ; sur la figure 1, la référence 20 désigne le contour de ce conducteur de masse, et la référence 18 désigne le contour du conducteur relié par des bords évasés à la zone de connexion conductrice essentiellement carrée.

L'ensemble du substrat semiconducteur est recouvert d'une couche diélectrique relativement épaisse 24 (de l'ordre de 10 micromètres), de préférence du BCB (benzo-cyclo-butène) qui a de bonnes propriétés diélectriques en hyperfréquence. Une ouverture 26 est formée dans le BCB au-dessus de la zone conductrice 16, au milieu de cette dernière. Le fond de l'ouverture 26 est occupé par la zone 16 d'aluminium. Sur la figure 1, le fond de l'ouverture est représenté par un contour tireté 25 de surface inférieure à celle de la zone de connexion 16. L'ouverture 26 ne dénude donc que la zone de connexion et même une partie seulement de cette dernière. Le haut de l'ouverture 26 est désigné par un contour tireté 27 plus grand que le contour 25 du fait que l'ouverture est à flancs obliques.

La ligne de transmission hyperfréquence, à laquelle on veut relier électriquement la zone 16, est de préférence un conducteur de cuivre 28 déposé sur la couche de BCB 24. A l'endroit de la liaison, le conducteur de cuivre 28 descend le long des flancs de l'ouverture 26 formée dans le BCB, recouvre toute la partie dénudée de la zone conductrice 16, et remonte sur tous les côtés de l'ouverture. Le conducteur 28 déborde partout autour de l'ouverture. II est donc plus large que l'ouverture à l'endroit de celle-ci, comme le montre le contour représenté sur la figure 1.

Cette structure classique oblige à donner une surface importante à la zone de connexion conductrice 16 ; la capacité parasite avec le substrat est importante ; elle détériore donc la qualité de la transmission hyperfréquence.

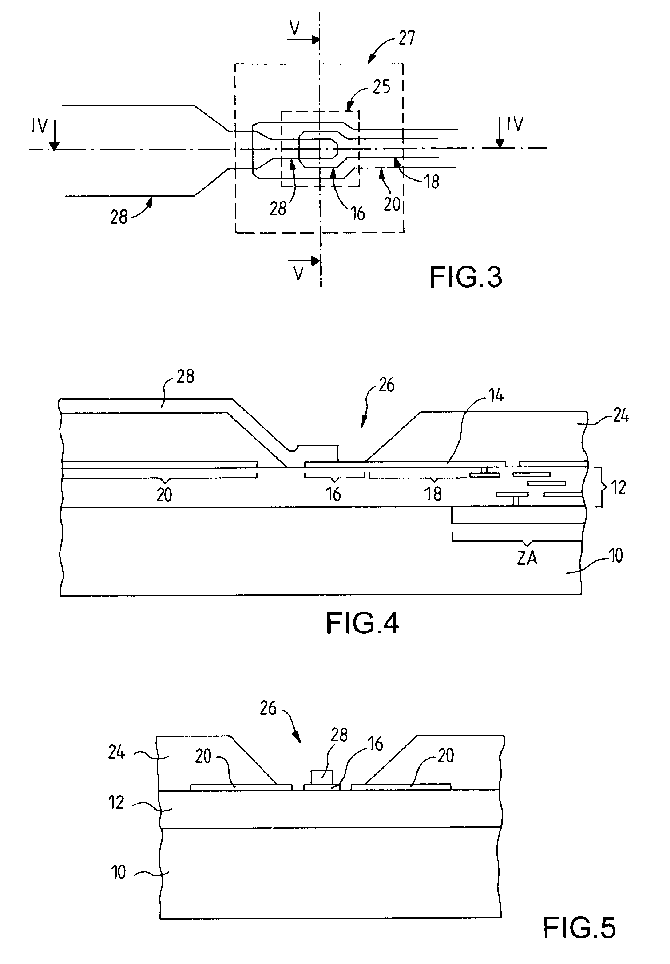

L'invention propose une structure de liaison différente entre la ligne de transmission hyperfréquence et les éléments actifs ou passifs du circuit intégré. Cette liaison est représentée à la figure 3 (vue de dessus), à la figure 4 (vue en coupe selon la ligne IV-IV de la figure 3), et à la figure 5 (vue en coupe selon la ligne V-V de la figure 3). Sur ces figures on a repris les mêmes références qu'aux figures 1 et 2 pour les éléments semblables. Les figures 1, 2, 3, 4 et 5 sont toutes constituées à la même échelle en prenant pour base une dimension carrée identique pour le bas de l'ouverture de la couche de BCB (contour tireté 25) afin de bien faire apparaître la réduction de dimensions des parties conductrices qui amènent des capacités parasites.

La zone de connexion conductrice 16 occupe maintenant une surface plus petite que le bas de l'ouverture formée dans la couche de BCB.

L'ouverture dans le BCB dénude l'ensemble de la zone conductrice 16. Elle dénude aussi une partie de surface de la couche isolante 12 non recouverte par la couche d'aluminium 14. Elle peut même dénuder en partie le conducteur de masse 20 qui entoure la zone 16, comme c'est visible sur les figures 3 et 5.

Par ailleurs, la ligne de transmission hyperfréquence en cuivre vient recouvrir une partie de la zone dénudée de la zone conductrice 16 mais pas la totalité de cette zone dénudée de la zone 16 (cf. figure 5), pour centrer correctement la ligne sur la zone et éviter de faire un court-circuit avec la masse 20 en cas de léger désalignement.

Il en résulte une disposition dans laquelle la surface conductrice à l'endroit du contact est particulièrement réduite, que ce soit celle de la zone conductrice 16 ou celle de l'extrémité de ligne de transmission présente dans l'ouverture du BCB. La capacité de couplage entre ces zones métalliques et le substrat de silicium est minimisée.

Sur la figure 3, on voit comment la ligne de transmission hyperfréquence se rétrécit avant de descendre dans le fond de l'ouverture 26 et vient se poser sur une partie seulement de la zone de connexion 16 sans remonter sur les bords latéraux de cette ouverture, ou en tous cas sans remonter de tous les côtés sur les bords latéraux comme c'était le cas dans l'art antérieur. Dans la configuration représentée, la connexion ne remonte sur aucun des bords latéraux.

Sur les figures 1 à 5, on n'a pas représenté les couches supplémentaires d'isolation ou de protection qui recouvrent la ligne de transmission et l'ouverture formée dans le BCB. Toutefois de telles couches seront prévues dans une structure de circuit intégré terminée. Les figures 3 à 5 représentent donc le circuit intégré à un stade intermédiaire de fabrication.

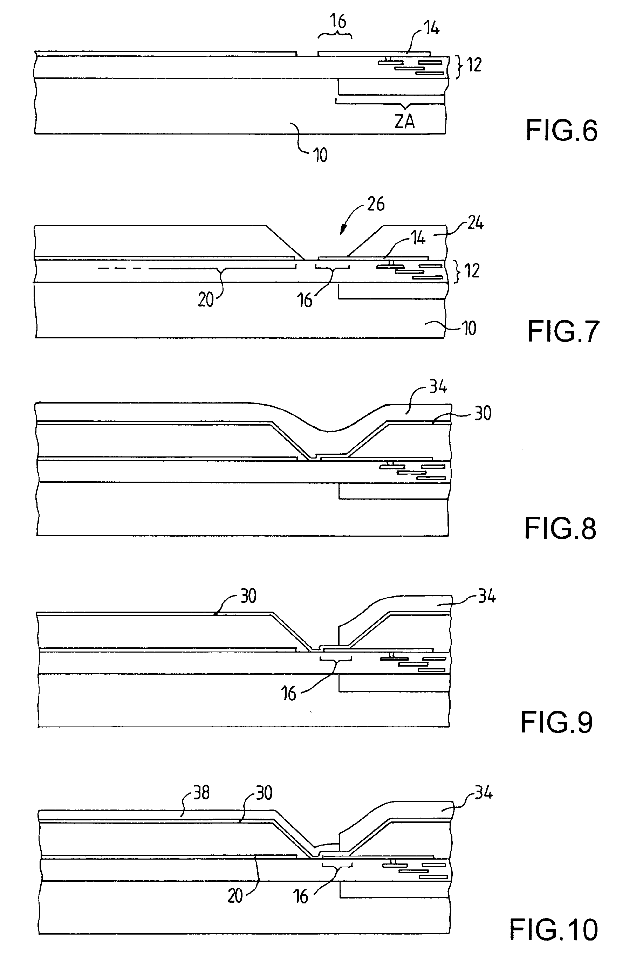

On va maintenant décrire en référence aux figures 6 à 14 le procédé de fabrication selon l'invention, permettant de réaliser une structure de liaison électrique conforme à ce qui vient d'être décrit.

On part d'un substrat de silicium 10 sur lequel on forme, dans une zone active ZA, les éléments actifs et passifs et leurs interconnexions par des étapes classiques de dépôts, gravures de couches conductrices, semiconductrices et isolantes, implantations d'impuretés, diffusions, traitements thermiques.

Les interconnexions sont formées sur plusieurs niveaux dans une couche globalement isolante 12 (oxyde de silicium de quelques micromètres d'épaisseur globale) ; les connexions sont de préférence en aluminium, ou en cuivre ou en alliage de silicium et d'aluminium ou silicium et cuivre, de même que les vias de connexion entre les différents niveaux.

Le dernier niveau d'interconnexion est celui de la couche 14 qui servira à établir une liaison avec une ligne de transmission hyperfréquence déposée ultérieurement. La couche 14 est de préférence en aluminium revêtu d'une fine couche de titane. La figure 6 représente le substrat à ce stade de la fabrication.

On fait l'hypothèse, dans cet exemple de réalisation, que la ligne de transmission hyperfréquence servira à relier une zone conductrice 16 formée dans la couche 14 à un plot de connexion extérieure du circuit intégré, de manière que les éléments actifs soient raccordés par une ligne hyperfréquence de bonne qualité à ce plot de connexion extérieure.

On dépose uniformément une couche de benzo-cyclo-butène 24, par exemple sur une épaisseur d'environ 10 micromètres ; on ouvre dans cette couche, par un procédé lithographique, une ouverture à flancs obliques 26 dénudant complètement la zone 16 et dénudant une partie de la couche isolante 12 qui l'entoure. L'ouverture 26 peut même dénuder en partie le conducteur de masse 20 formé dans la couche 14 et entourant la zone conductrice 16, selon une configuration telle que représentée aux figures 3 à 5.

Pour la formation de l'ouverture 26, on peut profiter de ce que la couche de BCB est photosensible pour faire une photolithographie directe sur cette couche et éliminer la partie de BCB non insolée à travers le masque qui définit l'ouverture 26. Cette étape produit naturellement une ouverture à flancs obliques.

La figure 7 représente le substrat à ce stade, avec l'ouverture 26 à flancs obliques. La dimension de l'ouverture est aussi faible que possible compte-tenu des possibilités de la photolithographie pour l'épaisseur de couche présente. Typiquement, on peut ouvrir correctement une ouverture d'environ 15 micromètres de côté à la base, cette ouverture ayant plutôt 35 micromètres de côté en haut si l'épaisseur de la couche est d'environ 10 micromètres.

Une étape de recuit stabilise et réticule la résine BCB. Une étape de nettoyage par plasma permet d'éliminer les résidus non désirés au fond des ouvertures 26.

On dépose alors par évaporation une sous couche conductrice 30 sur l'ensemble du substrat. Cette couche 30 se dépose de manière continue dans les ouvertures 26 et en dehors des ouvertures. Elle peut être composée de deux couches distinctes, par exemple une fine couche de titane surmontée d'une fine couche de cuivre, par exemple 200 angströms de titane et 1000 angströms de cuivre.

Puis on dépose une couche de résine photosensible 34 en vue de définir les zones de croissance électrolytique du cuivre. Comme la résine tend à s'accumuler dans les ouvertures 26, en épaisseur plus grande qu'en dehors des ouvertures, on a représenté sur la figure 8 un profil d'épaisseur irrégulier de la résine 34. L'épaisseur est par exemple de 3 micromètres sur le BCB 24 et peut atteindre 5 micromètres dans les ouvertures 26.

On insole ensuite la résine à travers un masque pour définir les parties de résine à conserver et les parties de résine à enlever. Le cuivre se déposera sur la sous-couche 30 là où elle n'est plus recouverte de résine.

En raison de l'irrégularité d'épaisseur de la résine, on préfère insoler la résine en deux étapes : une première étape consiste à insoler la résine à travers un masque ouvert principalement au-dessus du motif de ligne de transmission à réaliser à l'intérieur de l'ouverture 26 et sur le ou les flanc(s) oblique(s) mais pas sur la partie principale de la ligne de transmission dont les dimensions doivent être bien précises ; le temps d'exposition est adapté au fait que la résine est plus épaisse dans l'ouverture et sur les flancs ; une deuxième étape consiste à insoler la résine à travers un masque ouvert au-dessus du motif de ligne de transmission à réaliser en dehors de l'ouverture (et éventuellement à nouveau dans l'ouverture et sur le ou les flancs) ; le temps d'exposition est plus court que dans la première étape. La résine est ainsi mieux insolée là où elle est plus épaisse (dans le fond de l'ouverture et sur les flancs) sans que les dimensions latérales de la ligne de transmission soient affectées par une insolation trop longue.

La résine 34 est développée après ces deux étapes d'insolation (dont l'ordre peut être inversé) et elle est enlevée là où elle a été insolée, c'est-à-dire sur tout le motif de ligne de transmission à réaliser, tant dans l'ouverture 26 qu'en dehors de l'ouverture 26. La figure 9 représente le substrat à ce stade : la sous-couche de titane/cuivre est dénudée sur le motif de ligne de transmission à réaliser, et notamment sur une partie de la zone de connexion 16, mais pas sur la totalité de celle-ci.

On effectue alors (figure 10) une étape de croissance électrolytique d'une couche de cuivre 38 sur les conducteurs non protégés par la résine 34. La croissance est faite par exemple sur une épaisseur d'environ 2 micromètres, en tous cas une épaisseur largement supérieure à l'épaisseur de cuivre de la sous-couche 30. La croissance définit les lignes de transmission hyperfréquence dont le motif avait été défini par l'ouverture dans la résine 34. On voit que ces lignes viennent en contact dans l'ouverture 26 à la fois avec une portion de la zone de connexion 16 dénudée et avec l'isolant 12 qui l'entoure. Elles ne viennent pas en contact avec les lignes de masse 20 (cf. figure 5) même si celles-ci affleurent dans l'ouverture 26.

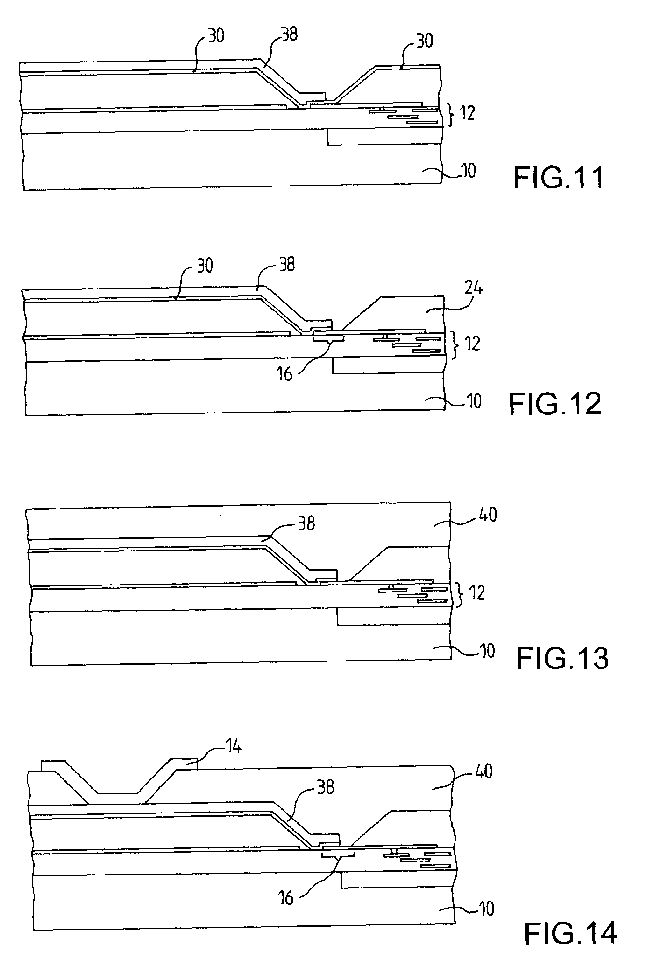

On enlève la résine après la croissance électrolytique du cuivre (figure 11). Le substrat est recouvert partout de la sous-couche 30 et il est recouvert par le cuivre électrolytique 38 sur les lignes de transmission.

On attaque légèrement tout le substrat avec un produit d'attaque du cuivre, pendant une durée suffisante pour enlever le cuivre de la sous-couche 30 là où il n'est pas recouvert par la couche électrolytique 38, mais insuffisante pour enlever une épaisseur importante de la couche 38.

On attaque ensuite la couche de titane de la sous-couche conductrice 30, de préférence avec un produit qui n'attaque pas le cuivre. On retrouve alors (figure 12) la couche de BCB 24 nue, et sur cette couche, les lignes de transmission formées par la superposition de la couche de cuivre électrolytique 38 un peu amincie et de la sous-couche 30 qui lui a servi de base d'électrolyse.

Le via conducteur selon l'invention est alors défini. On peut continuer le procédé par exemple par le dépôt d'une nouvelle couche de BCB 40, l'ouverture de cette couche pour former un via de contact avec la ligne de transmission 38, et la formation d'une autre ligne de transmission ou de plots de connexion extérieure 44 par dépôt et gravure de métal ou par un procédé utilisant l'électrolyse tel que celui qui a été décrit ci-dessus.

Des mesures ont montré que des pertes de transmission évaluées à 0,4 dB par via conducteur à 40 GHz pouvaient être ramenées par cette structure à 0,1 dB par via.

Pour obtenir de bons résultats, la pente des flancs obliques de l'ouverture formée dans la résine BCB est de préférence comprise entre 35° et 60°, de préférence entre 40° et 50°, par exemple autour de 45°. SI la pente est trop forte, la réalisation de la ligne de transmission est plus difficile notamment à cause des étapes de photolithographie. Si elle est trop faible, la capacité parasite entre la ligne radiofréquence et le substrat devient trop importante.

Pour adapter l'angle à une valeur désirée, on fait varier le temps d'exposition de la résine, ou bien on fait varier la distance entre le masque de photolithographie et le substrat. Par exemple, pour un dépôt de 10 micromètres d'épaisseur de BCB, avec une distance entre masque et substrat de 20 micromètres, on expose pendant 100 secondes avec une lampe de puissance 16 mW/cm² et on obtient une pente de 45° environ. Plus précisément, c'est la dose d'insolation reçue par la résine BCB photosensible qui est importante, la dose étant la puissance reçue multipliée par le temps d'insolation. Avec une résine BCB photosensible on sait bien faire une pente d'environ 45°. Avec une résine BCB non photosensible on pourra obtenir des flancs plus abrupts.

Dans une variante de réalisation, on cherche à faire des lignes de transmission en aluminium ou en alliage d'aluminium et de silicium, et la croissance électrolytique ne s'y prête pas. On procède donc différemment après la formation de l'ouverture 26 dans la couche de BCB : on dépose une couche d'accrochage métallique (titane par exemple) facilitant l'adhérence ultérieure de la ligne ; puis on dépose une couche métallique en aluminium ou alliage aluminium-silicium formant le matériau principal de la ligne proprement dite ; par exemple on dépose 2 micromètres d'épaisseur d'aluminium ; on dépose ensuite et on photograve une résine selon un motif défini par au moins un masque ; la résine subsistant après développement définit le motif de ligne de transmission ; on grave la couche métallique là où elle n'est pas protégée par la résine et on grave la couche d'accrochage là où elle est dénudée par l'enlèvement de la couche métallique. La ligne de transmission qui subsiste est la superposition de la couche d'accrochage et de la couche métallique.

Là encore, on peut procéder à la photogravure de la résine en deux étapes d'insolation, à travers deux masques différents, pour bien insoler la résine là où elle est plus épaisse (dans l'ouverture 26 et sur les flancs), tout en limitant l'insolation au-dessus de la couche de BCB pour que la géométrie de la ligne de transmission reste bien précisément définie.

Un premier masque peut définir la ligne de transmission dans son ensemble (extérieur et intérieur de l'ouverture, ou seulement l'extérieur) ; un deuxième masque peut définir une zone d'enlèvement de la résine dans l'ouverture et sur les flancs.

La résine est développée après ces deux insolations successives.

## Revendications

1. Procédé de fabrication d'un circuit intégré hyperfréquence sur un substrat de silicium ou germanium, comprenant la réalisation sur une face principale du substrat (10) d'éléments actifs et d'au moins une zone de connexion conductrice (16) pour la liaison entre un élément actif et une ligne de transmission hyperfréquence (28), le dépôt d'au moins une couche diélectrique (24) sur la face principale du substrat, la réalisation dans la couche diélectrique d'une ouverture (26) dénudant la zone de connexion, la formation d'une couche conductrice (28) selon une géométrie correspondant à la ligne de transmission, ce procédé étant **caractérisé en ce que** la base (25) de l'ouverture est plus grande que la zone de connexion dénudée par l'ouverture et **en ce que** la géométrie de la couche conductrice (30) définit un motif de ligne qui descend dans l'ouverture et recouvre une partie seulement de la surface de zone de connexion dénudée par l'ouverture.

2. Procédé selon la revendication 1, **caractérisé en ce que** la couche diélectrique est en benzo-cyclo-butène.

3. Procédé selon l'une des revendications 1 et 2, **caractérisé en ce que** la ligne de transmission est en cuivre.

4. Procédé selon la revendication 3, **caractérisé en ce que** la ligne de transmission est formée par dépôt d'une sous-couche conductrice (30), dépôt et insolation d'une résine à travers un masque, enlèvement de la résine sur un motif défini par le masque, et croissance électrolytique sur la sous-couche conductrice non protégée par la résine, selon le motif de la ligne de transmission à réaliser.

5. Procédé selon la revendication 4, **caractérisé en ce que** la définition de la géométrie des lignes de transmission est effectuée par une double étape d'insolation à travers deux masques dont l'un comporte un motif ouvert principalement au-dessus du motif de ligne de transmission à réaliser à l'intérieur de l'ouverture (26) et sur le ou les flanc(s) oblique(s) mais pas sur la partie principale de la ligne de transmission au-dessus de la couche de BCB, et l'autre comporte un motif ouvert au-dessus de la couche de BCB pour définir la ligne de transmission.

6. Procédé selon l'une des revendications 1 à 3, **caractérisé en ce que** la ligne de transmission est formée par dépôt d'une couche d'accrochage facilitant l'adhérence ultérieure de la ligne, puis dépôt d'une couche métallique en aluminium ou alliage aluminium-silicium, dépôt et photogravure d'une résine selon un motif défini par au moins un masque, et gravure de la couche métallique pour laisser subsister une ligne de transmission, et enfin gravure de la couche d'accrochage là où elle est dénudée par l'enlèvement de la couche métallique.

7. Procédé selon la revendication 6, **caractérisé en ce que** la définition de la géométrie des lignes de transmission est effectuée par une double étape d'insolation à travers deux masques pour établir une insolation plus importante dans l'ouverture et sur les flancs de l'ouverture que sur la couche de BCB.

8. Circuit intégré destiné à fonctionner en hyperfréquence, comportant un substrat de silicium dans une face principale duquel est intégré au moins un élément actif ou passif avec une zone de connexion conductrice (16) connectée à cet élément actif, une couche diélectrique (24) recouvrant la face principale du substrat, une ligne de transmission hyperfréquence conductrice (28) déposée au-dessus de la couche diélectrique, et une ouverture (26) à travers la couche diélectrique au-dessus de la zone de connexion, **caractérisé en ce que** la base (25) de l'ouverture est plus grande que la zone de connexion dénudée par l'ouverture et **en ce que** la ligne de transmission descend le long d'une pente oblique d'un flanc de l'ouverture et vient en contact avec la zone de connexion sur une surface plus faible que la surface de zone de connexion dénudée par l'ouverture.

9. Circuit selon la revendication 8, **caractérisé en ce que** la ligne de transmission s'arrête sur la zone de connexion sans remonter sur tous les bords de l'ouverture formée dans la couche diélectrique.

10. Circuit selon l'une des revendications 8 et 9, **caractérisé en ce que** la couche diélectrique est en benzo-cyclo-butène.

11. Circuit selon la revendication 10, **caractérisé en ce que** la zone de connexion est en aluminium ou en cuivre et la ligne de transmission est en cuivre ou en aluminium ou en alliage d'aluminium et de silicium.

12. Circuit selon l'une des revendications 8 à 11, **caractérisé en ce que** la pente de l'ouverture est comprise entre 35° et 60°, de préférence voisine de 45°.
